Europäisches Patentamt

European Patent Office

Office européen des brevets

(11) Numéro de publication: **0 462 345 A1**

# DEMANDE DE BREVET EUROPEEN

(21) Numéro de dépôt: **90401702.7**

(22) Date de dépôt: **18.06.90**

(51) Int. Cl.5: **H01L 25/04**

(43) Date de publication de la demande:
**27.12.91 Bulletin 91/52**

(84) Etats contractants désignés:
**DE GB IT NL**

(71) Demandeur: **COMMISSARIAT A L'ENERGIE ATOMIQUE Etablissement de Caractère Scientifique Technique et Industriel 31/33, rue de la Fédération F-75015 Paris(FR)**

(72) Inventeur: **Amingual, Daniel**
**2 rue Jean Macé**
**F-38000 Grenoble(FR)**
Inventeur: **Demay, Yves**
**34 rue Lénine**
**F-78210 St Cyr(FR)**
Inventeur: **Chamonal, Jean-Paul**
**6 rue Nicolas Chorier**
**F-38000 Grenoble(FR)**
Inventeur: **Tissot, Jean-Luc**
**3 bld de Jomardière**
**F-38120 St Egreve(FR)**

(74) Mandataire: **Mongrédien, André et al**
**c/o BREVATOME 25, rue de Ponthieu**
**F-75008 Paris(FR)**

(54) Elément de détection constitué de barrettes de détecteurs.

(57) Il comprend plusieurs barrettes (4), munies de capteurs (5) orientés vers un filtre (1) et reliées à lui par des billes métalliques (9, 12) utilisées déjà pour assurer les connexions électriques des capteurs (5) vers l'extérieur.

Application aux détecteurs de rayonnement infrarouge.

FIG. 2

La présente invention se rapporte à un élément de détection constitué de barrettes de détecteurs. De tels éléments sont utilisés notamment sur les satellites et les véhicules où ils peuvent servir de capteurs d'obstacles, et les barrettes portent généralement des détecteurs infrarouges dont chacun embrasse un petit angle solide d'un champ de vision et permet de reconstituer un point d'image.

Les détecteurs sont constitués en pratique d'une zone sensible au rayonnement à capter et d'une ligne de connexion électrique entre la zone sensible et un plot de connexion électrique. Les zones sensibles et les plots de connexion électrique sont situés sur une face plane de la barrette et forment deux alignements parallèles. Les barrettes sont collées par leur face opposée sur un substrat pourvu de pistes conductrices que l'on relie individuellement aux plots de connexion par des fils soudés. Ce procédé est peu pratique, surtout quand il faut abouter plusieurs barrettes les unes à côté des autres car le collage rend difficile l'alignement correct et parfaitement à plat des barrettes sur le substrat, d'autant plus que le durcissement des colles est un phénomène assez lent.

Dans le brevet français n°2 569 052, on utilise, pour remplacer les fils, des barrettes intermédiaires de liaison qui unissent par des aiguilles d'indium des plots de connexion électrique sur les barrettes de détecteurs et sur les circuits de lecture. Le montage de l'élément de détection est a lors plus rapide mais il est toujours nécessaire de devoir coller sur un substrat la barrette de détection et éventuellement le circuit de lecture.

D'après l'invention, on emploie un élément de détection de configuration entièrement nouvelle, dans lequel les barrettes sont retournées : les zones sensibles et les plots de connexion sont orientés vers le substrat, qui est évidemment transparent aux rayonnements que les barrettes doivent capter. Les pistes conductrices sont déposées directement sur le substrat suivant des techniques connues utilisées pour la fabrication des circuits intégrés par exemple, et les plots de connexion électrique sont reliés aux pistes du substrat par des billes de matériau conducteur électrique qui assurent donc à la fois les liaisons mécaniques et électriques.

Plus précisément, l'invention concerne un élément de détection constitué de barrettes de détecteurs, les détecteurs comprenant sur une face de la barrette une zone sensible à un rayonnement à détecter et un plot de connexion électrique relié à la zone sensible par une piste électrique, caractérisé en ce qu'il comprend un substrat transparent au rayonnement et portant des pistes conductrices électriques munies d'autres plots, en ce que ladite face des barrettes est orientée vers le substrat et en ce que les plots des barrettes et des pistes conductrices sont réunis par des billes conductrices.

Les billes conductrices sont avantageusement en alliage d'indium ; les plots peuvent alors être en or.

Pour consolider la fixation des barrettes de détection, on peut prévoir sur celles-ci et sur le substrat des plots additionnels qui seront également reliés par des billes métalliques.

L'invention va à présent être décrite à l'aide des figures suivantes annexées à titre illustratif et non limitatif :

- la figure 1 représente une vue en perspective avec arrachement partiel des éléments de détection suivant l'invention ;
- les figures 2 et 3 représentent deux coupes de l'invention suivant les plans II-II et III-III des figures 1 et 2 ;
- la figure 3' est une variante de la figure 3 ; et
- la figure 4 représente un mode concret d'intégration de l'invention dans un dispositif de détection.

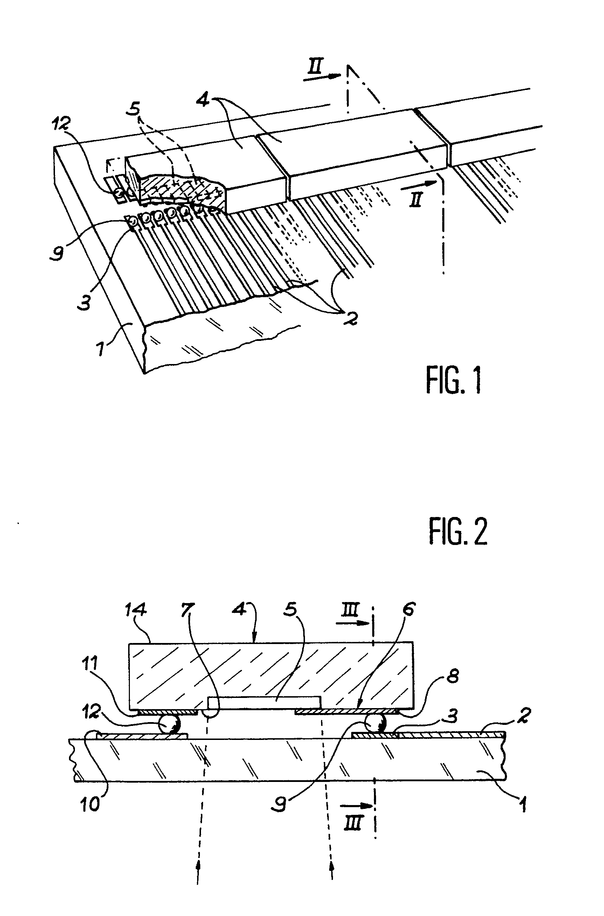

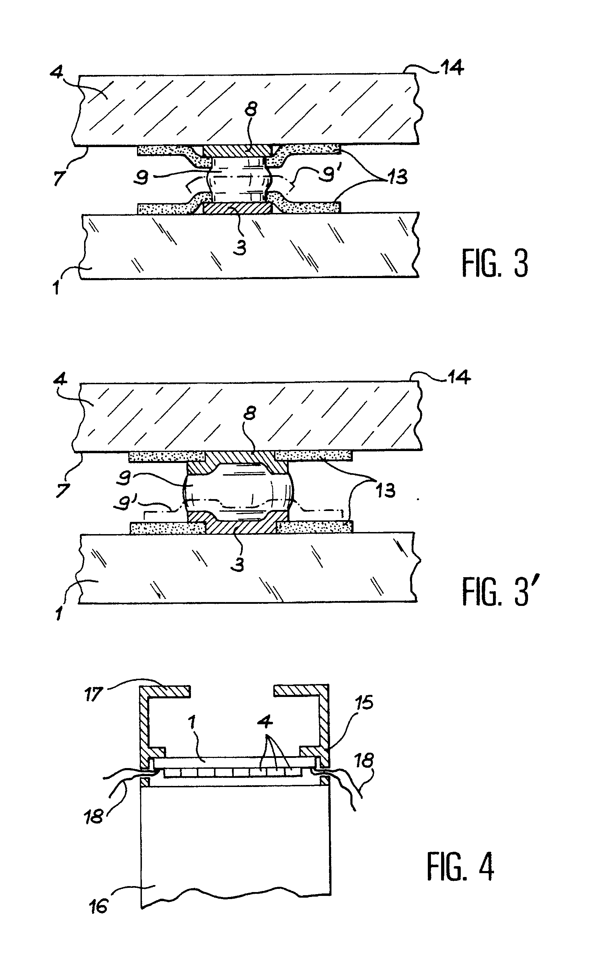

On distingue sur la figure 1 un filtre 1 transparent à un rayonnement infrarouge à capter et sur la surface duquel des pistes 2 conductrices de l'électricité sont déposées. Les pistes 2 forment un réseau parallèle et se terminent chacune par un plot de connexion 3. Des barrettes de détecteurs 4 sont disposées au-dessus et à faible distance des plots 3 ; les barrettes 4 sont jointives et aboutées suivant un alignement parallèle aux plots 3. Comme on le voit sur les figures 2 et 3, les barrettes 4 portent des détecteurs constitués chacun d'une zone 5 sensible aux rayonnements à capter et constituée d'un cristal ayant des propriétés photovoltaïques ou photoconductrices vis-à-vis du rayonnement à capter. Une ligne de connexion électrique 6 part de chaque zone sensible 5 parallèlement aux pistes 2 et aboutit à un plot de connexion 8. Zones sensibles 5 et lignes de connexion 6 forment un réseau dont le pas est égal à celui des pistes 2, sur la face 7 des barrettes 4 orientée vers le filtre 1. Pour fabriquer l'élément de détection objet de l'invention, on place face à face les plots 3 et 8 des pistes 2 et des lignes de connexion 6 avant de les souder par une bille intermédiaire conductrice 9 qui les joint et qui peut être en indium ou en alliage d'indium comme il est usuel dans cette technique. Les billes 9 réalisent donc à la fois la liaison électrique et la liaison mécanique entre les barrettes 4 et leur substrat ou support, constitué ici par le filtre 1. Dans le cas usuel où les zones sensibles 5 sont toutes alignées et munies de lignes de connexion électrique 6 orientées dans le même sens, la solidité de la liaison peut être améliorée si on dispose sur le filtre 1 et la barrette 4 des plots additionnels référencés respectivement 10 et 11. Les plots additionnels 10 et 11 sont ensuite reliés par des billes additionnelles 12 pour constituer une deuxième ligne de liaison des barrettes 4 sur leur bord opposé à celui qui porte les plots de connexion 8.

La fabrication ne suscite pas de problèmes particuliers. On dispose en effet de machines qui permettent de maintenir côte à côte avec une grande précision le filtre 1 et les barrettes 4 avant de réaliser la soudure par les billes 9 et 12. La principale contrainte de conception consiste à apposer les pistes 2 et les plots 3 et 10 du filtre 1 en dehors du champ de vision des zones sensibles 5, ce qui est cependant facile à respecter en pratique.

Comme le montrent les figures 3 et 3', on peut avantageusement appliquer à cette invention une technique de connexion comme dans l'art antérieur. Les plots, par exemple 3 et 8, sont chacun entourés de feuilles isolantes 13. Les feuilles isolantes 13 peuvent recouvrir partiellement les plots 3 et 8 comme représenté figure 3 ou être recouvertes par ceux-ci comme représenté figure 3'. Une pastille du matériau dont on veut réaliser la bille 9, référencée ici 9', est tout d'abord déposée sur un des plots 3 et sur les feuilles isolantes 13 qui l'entourent. L'autre plot 8 est ensuite rapproché. On réalise la fusion de la pastille 9' en une gouttelette qui prend une forme moins aplatie et vient toucher l'autre plot 8. En effet, les plots 3 et 8 sont en matériau pouvant être mouillé par le matériau fondu de la bille 9, contrairement aux feuilles isolantes 13. Dans le cas de billes 9 en alliage d'indium, les plots 3 et 8 peuvent être en or et les feuilles 13 en silice ou nitrure de silicium. Un contact de bonne qualité de la bille 9 avec les plots 3 et 8 est ainsi obtenu. Le même procédé est aussi applicable aux billes additionnelles 12. Il faut cependant remarquer que les billes 12 et plots 10 et 11 additionnels peuvent être composés d'autres matériaux que ceux des billes 9 et plots 3 et 8 de connexion électrique, car leur rôle est purement mécanique.

On laisse ensuite les billes 9 et 12 se solidifier pour réaliser les soudures ; après quoi l'élément de détection constitué du filtre 1 et des barrettes 4 peut être retiré de la machine et utilisé. Le procédé est rapide et exclut les risques de défaut de planéité ou d'alignement de barrettes 4 qui sont beaucoup plus importants avec les procédés habituels où les barrettes 4 sont collées par leur face 14, opposée à la face 7 portant les zones visibles 5, sur le substrat.

La figure 4 représente un arrangement possible. La périphérie du filtre 1 porteur des barrettes 4 est fixée à un écran 15 cylindrique et disposé sur l'extrémité d'un doigt 16. L'écran 15 peut être terminé par un rebord couvrant 17 qui limite l'exposition du filtre 1. Le doigt 16 est refroidi par des circuits de fluide non représentés pour permettre une meilleure détection. Des circuits de lecture non représentés également peuvent être placés sur le filtre 1, à l'extrémité des pistes 2 opposées aux plots de connexion 3, pour permettre une exploitation aisée des mesures effectuées par les zones sensibles 5. Des fils électriques 18 relient alors les circuits de lecture à l'extérieur.

## Revendications

1. Elément de détection constitué de barrettes de détecteurs (4), les détecteurs comprenant sur une face (7) des barrettes (4) une zone sensible (5) à un rayonnement à détecter et un plot (8) de connexion électrique relié à la zone sensible (5) par une piste électrique (6), caractérisé en ce qu'il comprend un substrat (1) transparent au rayonnement et portant des pistes (2) conductrices électriques munies d'autres plots (3), en ce que ladite face (7) des barrettes (4) est orientée vers le substrat (1) et en ce que les plots (3, 8) des barrettes et des pistes conductrices sont réunis par des billes conductrices (9).

2. Elément de détection suivant la revendication 1, caractérisé en ce que les billes conductrices (9) sont en alliage d'indium.

3. Elément de détection suivant la revendication 2, caractérisé en ce que les plots (3, 8) sont en or.

4. Elément de détection suivant l'une quelconque des revendications 2 ou 3, caractérisé en ce que les plots sont partiellement entourés, sur des parties périphériques opposées, de feuilles de matériau isolant (13) non mouillable par l'alliage d'indium.

5. Elément de détection suivant l'une quelconque des revendications 1 à 4, caractérisé en ce que les barrettes et le substrat comprennent des plots additionnels (10, 11) reliés par des billes addditionnelles (12).

6. Elément de détection suivant l'une quelconque des revendications 1 à 5, caractérisé en ce que les barrettes (4) sont jointives et aboutées.

FIG. 1

FIG. 2

FIG. 3

FIG. 3′

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | PATENT ABSTRACTS OF JAPAN vol. 9, no. 61 (E-303)(1784) 19 mars 1985, & JP-A-59 198770 (FUJI DENKI SEIZO K.K.) 10 novembre 1984, * le document en entier * | 1 | H01L25/04 |
| A,D | FR-A-2569052 (THOMSON CSF) * page 3, ligne 26 - page 4, ligne 26; figure 1 * | 1, 2, 3 | |
| A | FR-A-2494910 (THOMSON CSF) * page 3, ligne 25 - page 4, ligne 25; figure 1 * | 1, 2 | |
| A | INTERNATIONAL ELECTRON DEVICES MEETING 09 décembre 1984, SAN FRANSISCO US pages 389 - 392; J.P.ROSBECK ET AL.: "SURFACE LEAKAGE CURRENT MECHANISMS IN HgCdTe GATE CONTROLLED PHOTODIODES" * le document en entier * | 1, 2 | |
| A | FR-A-2541044 (ETA S.A.) * le document en entier * | 1, 4 | **DOMAINES TECHNIQUES RECHERCHES (Int. Cl.5 )** |
| A | EP-A-201396 (THOMSON CSF) * colonne 4, lignes 9 - 14 * | 1, 6 | H01L |
| E | FR-A-2644632 (CEA) * le document en entier * | 1-6 | |

Le présent rapport a été établi pour toutes les revendications

| Lieu de la recherche | Date d'achèvement de la recherche | Examinateur |
|---|---|---|
| LA HAYE | 20 FEVRIER 1991 | LINA F. |

EPO FORM 1503 03.82 (P0402)